Europäisches Patentamt

European Patent Office

Office européen des brevets

(11) Numéro de publication: **0 377 365**
**A1**

## (12) DEMANDE DE BREVET EUROPEEN

(21) Numéro de dépôt: **89403511.2**

(22) Date de dépôt: **15.12.89**

(51) Int. Cl.5: **H01L 21/321, H01L 21/312, H01L 21/336, H01L 27/13**

(30) Priorité: **19.12.88 FR 8816737**

(43) Date de publication de la demande:
**11.07.90 Bulletin 90/28**

(84) Etats contractants désignés:
**BE DE GB IT NL SE**

(71) Demandeur: **ETAT FRANCAIS représenté par le Ministre des Postes, Télécommunications et de l'Espace
(CENTRE NATIONAL D'ETUDES DES TELECOMMUNICATIONS) 38-40 rue du Général Leclerc
F-92131 Issy-les-Moulineaux(FR)**

(72) Inventeur: **Chouan, Yannick
1 Allée des Fougères
F-22700 Louannec(FR)**
Inventeur: **Favennec, Jean-Luc
16, Cité du Vallon
F-22700 Saint Quay Perros(FR)**

(74) Mandataire: **Mongrédien, André et al
c/o BREVATOME 25, rue de Ponthieu
F-75008 Paris(FR)**

(54) **Procédé de gravure d'une couche d'oxyde métallique et dépôt simultanés d'un film de polymère, application de ce procédé à la fabrication d'un transistor.**

(57) Le procédé selon l'invention consiste à soumettre une couche d'oxyde métallique (106, 108), disposée sur un substrat en verre (100), à l'action d'un plasma gazeux (109) contenant 10 à 88% en volume d'hydrogène, 2 à 30% en volume d'un hydrocarbure et 10 à 50% d'un gaz vecteur inerte, entraînant la formation d'une couche de polymère (110) sur les parties du substrat non pourvues d'oxyde, par dissociation du mélange gazeux, et la gravure chimique partielle de l'oxyde (106, 108) par formation d'organométalliques.

FIG. 1

## PROCEDE DE GRAVURE D'UNE COUCHE D'OXYDE METALLIQUE ET DEPOT SIMULTANES D'UN FILM DE POLYMERE, APPLICATION DE CE PROCEDE A LA FABRICATION D'UN TRANSISTOR

La présente invention a pour objet un procédé de gravure anisotrope d'une couche d'oxyde métallique et de dépôt simultanés d'un film de polymère. Elle trouve une application en microélectronique et en particulier dans la réalisation de circuits d'affichage pour les écrans plats à cristaux liquides. L'invention permet en particulier la fabrication de transistors en couches minces à base de silicium amorphe hydrogéné, utilisés dans les écrans d'affichage à matrice active.

La fabrication de transistors en couches minces (TCM) passe généralement par la réalisation d'une gravure d'une couche conductrice ou d'une couche isolante en oxyde métallique. Cette gravure d'oxyde métallique est généralement effectuée par voie humide en utilisant une solution contenant de l'acide chlorhydrique portée à 55°C environ. Les techniques dites humides sont limitées par leur caractère isotrope, ce qui ne permet pas d'obtenir des motifs gravés parfaitement bien définis, ayant des dimensions microniques, voire submicroniques. Ce type de gravure est difficilement contrôlable.

Par ailleurs, lors de la réalisation de transistors en couches minces sur un substrat en verre, la gravure de l'oxyde métallique en solution chlorhydrique, et en particulier de l'oxyde d'indium et d'étain (ITO), provoque une gravure partielle du verre et une migration des ions chlore dans le substrat en verre. Lors de la fabrication de TCM à base de silicium amorphe hydrogéné au contact direct du verre, la migration des ions chlore dans le silicium amorphe modifie ses propriétés semi-conductrices entraînant une dégradation des propriétés électriques et une durée de vie de ces transistors limitée.

Le premier but de l'invention est donc un procédé de gravure d'un oxyde métallique permettant de remédier à ces inconvénients.

Par ailleurs, il est connu de déposer des films de carbone amorphe hydrogéné ou de polymère sur des substrats en silicium ou en matériau III-V par la technique de dépôt chimique en phase vapeur assisté plasma. A cet effet, on peut citer les articles de R. Memming "Properties of polymeric layers of hydrogenated amorphous carbon produced by a plasma-activated chemical vapour deposition process", paru dans Thin Solid Films, 143- (1986), p. 31-41 et p. 279-289 et dans l'article de John J. Pouch et al. "Plasma deposition of amorphous hydrogenated carbon films on III-V semiconductors" de Thin Solid Films, 157(1988), p. 97-104 et dans le document FR-A-2 514 743.

Ces films polymériques sont généralement utilisés comme matériaux de protection des composants optiques ou électriques.

En outre, il est connu de graver des matériaux semi-conducteurs III-V en utilisant un mélange de méthane, d'argon et d'hydrogène par le document Electronics Letters de novembre 1987, vol. 23, n° 24, p. 1253-1254 "Novel process for integration of optoelectronic devices using reactive ion etching without chlorinated gas" de L. Henry et al.

Dans cet article la formation d'un dépôt de polymère, pendant la gravure des composés III-V y est signalée, et est considérée comme un dépôt parasite non utilisable résultant d'un effet non recherché et qui doit être nécessairement éliminé pour réaliser le dispositif semi-conducteur envisagé. Différentes techniques y sont citées pour l'élimination de ce film polymérique.

En plus de la gravure d'une couche d'oxyde métallique, l'invention permet de déposer simultanément un film de polymère entrant en particulier dans la structure d'un composant semiconducteur tel qu'un transistor en couches minces.

Aussi, le procédé de l'invention met en valeur, sur un même substrat, le dépôt sélectif d'un polymère hydrocarboné associé à la gravure simultanés d'une couche mince d'oxyde métallique. Ce procédé met donc en valeur le dépôt de polymère considéré jusqu'à ce jour comme nuisible dans les procédés de gravure par plasma.

L'invention a donc pour objet un procédé de gravure anisotrope d'une couche d'oxyde métallique par formation d'organométalliques, disposée sur un substrat, et simultanément dépôt d'un film de polymère sur les parties du substrat, non pourvues d'oxyde, consistant à soumettre l'ensemble à un plasma formé à partir d'un mélange gazeux contenant de l'hydrogène et au moins un hydrocarbure qui, par dissociation, conduit à la formation du polymère et à ladite gravure en réagissant chimiquement avec la couche d'oxyde.

Les inventeurs ont trouvé qu'en ajustant les conditions de tension de polarisation du substrat, de pression, de débit de chacun des gaz et la composition du mélange gazeux, il est possible de créer une cinétique de gravure chimique d'une couche mince d'oxyde métallique, parfaitement anisotrope, avec des vitesses de l'ordre de 5 à 10 nm/min.

En particulier, il est possible de graver une couche d'oxyde d'indium et d'étain ayant une épaisseur allant jusqu'à 225 nm avec une parfaite anisotropie, contrairement au procédé de l'art antérieur.

Ce procédé de gravure est beaucoup moins polluant que les procédés par voie humide et il est facilement contrôlable.

La gravure de la couche d'oxyde métallique est obtenue lorsque les conditions de gravure permettent une réaction chimique entre le plasma et la couche à graver qui conduit à la formation de composés organométalliques généralement volatils, qui sont éliminés ensuite par le système de pompage du réacteur dans lequel se fait la gravure.

Par ailleurs, dans ces mêmes conditions, on obtient le dépôt d'un film de polymère sur le substrat, en dehors des zones recouvertes d'oxyde métallique. La vitesse de dépôt obtenue est de l'ordre de 3 à 6 nm/min.

De plus, les inventeurs ont trouvé que lorsque la couche d'oxyde métallique est entièrement gravée, la cinétique de gravure s'arrête et est immédiatement remplacée par une cinétique de dépôt d'un film de polymère sur le substrat alors mis à nu.

Les films de polymère déposés conformément à l'invention présentent un certain nombre de propriétés. En particulier, la croissance de ces films est parfaitement homogène sur une grande surface et ce, indépendamment de la nature du substrat. A titre d'exemple, le gradient d'épaisseur mesuré sur une cathode de 330 mm est inférieur à 5%. En outre, les films polymériques présentent une surface parfaitement lisse, une grande adhérence au substrat et une dureté qui les rend difficilement rayables.

Les propriétés électriques des films déposés, et notamment leur conductivité électrique qui est inférieure à $10^{-10}$ ohms.cm, en font d'excellents isolants électriques.

La dualité dépôt/gravure est liée à la nature du mélange de gaz utilisé et aussi à la nature de la couche mince à graver.

D'une façon générale, un grand nombre d'associations d'hydrocarbures qui par dissociation permettent la formation d'un dépôt de polymère et d'autre part, la formation d'organométalliques volatils par réaction chimique avec la couche mince d'oxyde à graver peut être utilisé.

Pour que la cinétique de dépôt et celle de la gravure soient du même ordre de grandeur, on utilise un mélange de gaz contenant, essentiellement en volume, de 10 à 88% d'hydrogène, et par exemple de 45 à 81% ; de 2 à 30% ; d'au moins un hydrocarbure et par exemple de 4 à 20% et de 10 à 50% d'un gaz vecteur inerte, et par exemple de 15 à 35%.

De façon générale, les hydrocarbures utilisables dans l'invention sont ceux de la série des alcanes, des alcènes et des alcynes que l'on trouve chez tous les producteurs de gaz fournissant l'industrie de la microélectronique. En particulier, ces hydrocarbures comportent de 1 à 6 atomes de carbone. Ces hydrocarbures peuvent être saturés, insaturés ou aromatiques.

Comme hydrocarbures utilisables dans l'invention, on peut citer l'acétylène, le propadiène, l'éthylène, le butène, le propylène, le méthane, l'éthane, le butane, le propane, etc. En général, on utilise le méthane ou l'éthane.

Le gaz neutre vecteur dont le rôle est de bombarder la surface d'oxyde à graver et ainsi d'accélérer la formation des composés organométalliques volatils peut être un gaz rare ou de l'azote. Comme gaz rare, on peut citer le néon, l'argon, le krypton, le xénon.

La dualité dépôt/gravure peut être obtenue dans tous les types de réacteurs de gravure à plasma connus, indépendamment des facteurs géométriques et des groupes de pompage.

Afin de s'éloigner d'un régime de gravure ionique prépondérant par rapport au dépôt et à la réaction chimique entre le plasma et la couche d'oxyde métallique, il est souhaitable d'utiliser une tension d'auto-polarisation du substrat, qui est proportionnelle à la puissance injectée, inférieure à 250 V. En outre, la gamme de pression préférée s'étend de 1,35 à 13,5 kPa (10 mT à 100 mT).

Les oxydes métalliques destinés à être gravés par le procédé selon l'invention sont nombreux ; la caractéristique de ces oxydes est que leur métal peut former des organométalliques. Ces oxydes peuvent être conducteurs ou isolants ; ils peuvent être simples ou complexes.

En particulier, le procédé de l'invention peut être utilisé pour graver $ZnO$, $WO_3$, $MO_3$, $IrOH$, $SnO_2$, $In_2O_3$, $Ta_2O_5$, ou encore l'oxyde d'indium et d'étain (ITO).

Le procédé de dépôt et de gravure simultanés conformément à l'invention est tout à fait approprié à la fabrication d'un transistor à effet de champ en couches minces (TCM) sur un substrat isolant et en particulier sur un substrat de verre. Ce transistor est réalisé suivant la structure dite "empilée à grille dessus" semblable à celle utilisée pour la fabrication de matrices actives pour les écrans plats à cristaux liquides.

Aussi, l'invention a encore pour objet un procédé de fabrication d'un transistor en couches minces sur un substrat isolant, comprenant les étapes suivantes :

(a) formation, sur le substrat, de la source et du drain du transistor en un oxyde métallique conducteur,

(b) gravure chimique anisotrope partielle de l'oxyde métallique et dépôt simultanés d'un film de polymère sur le substrat dépourvu dudit oxyde métallique, en utilisant un plasma formé à partir d'un mélange gazeux contenant de l'hydrogène et au moins un hydrocarbure, ce dépôt de polymère constituant une passivation du substrat et/ou un masque optique sous le canal du transistor,

(c) dépôts successifs, sur la structure obtenue en. (b), d'une couche de silicium amorphe hydrogéné, d'une couche d'isolant électrique puis d'une couche conductrice,

(d) photogravure de l'empilement formé par la couche de silicium, la couche d'isolant et la couche conductrice pour former la grille du transistor.

Ce procédé ne comporte aucune étape critique. Il permet en outre de passiver le substrat. En effet, dans le cas particulier d'un substrat en verre, la couche de polymère empêche toute migration des ions du verre tels que les ions de sodium, de potassium, de fluor, de phosphore, etc... entrant dans la composition des verres mais aussi des impuretés telles que les ions chlore introduites dans ces verres lors de traitement chimique précédant le dépôt de polymère. Ainsi, les propriétés électriques du transistor obtenu n'évoluent pas dans le temps, augmentant ainsi sa durée de vie.

En outre, il est possible d'utiliser des verres de qualités médiocres tels que des verres sodo-calciques, de faibles coûts.

La croissance du film de polymère se faisant avec une grande intimité le long des flancs de l'oxyde métallique que l'on grave, il est possible d'obtenir des structures planes en ajustant le temps d'exposition du substrat au plasma pour que l'épaisseur du polymère déposé et l'épaisseur de l'oxyde métallique non gravé soient égales. En particulier, des différences d'épaisseur inférieures à 10 nm peuvent être obtenues.

On obtient ainsi une structure dite coplanaire permettant ainsi de déposer dans un même plan les couches minces constituant le transistor proprement dit et en particulier la couche de silicium amorphe hydrogéné. On élimine ainsi les points faibles de la structure liés aux passages de marches qui peuvent être source de défauts dans les transistors.

De ce fait, il est possible d'utiliser une couche de silicium amorphe hydrogéné très mince (inférieure à 20 nm) et ainsi de limiter sa sensibilité photoélectrique.

Les matrices actives des transistors en couches minces réalisées en silicium amorphe hydrogéné, utilisées dans les écrans plats, sont sensibles à la lumière généralement utilisée pour l'éclairage de ces écrans. En effet, lorsque cette lumière est intense un photo-courant est engendré dans la couche de silicium amorphe diminuant le contraste de l'écran car le rapport Ion/Ioff diminue ; Ion et Ioff représentent respectivement les courants délivrés par les transistors d'un point affiché et d'un point non affiché.

Dans le procédé conforme à l'invention, la formation de polymère entre la source et le drain du transistor, sous le canal du transistor, permet la réduction de l'effet photoélectrique du silicium amorphe en jouant le rôle de masque optique ; les polymères déposés selon l'invention présentent en effet une forte absorption dans le domaine visible pouvant aller jusqu'à 40%.

Par ailleurs, le procédé selon l'invention permet maintenant d'envisager la réalisation complète d'un transistor en couches minces ainsi que la réalisation des autres composants électriques d'un écran plat, tels que les lignes et colonnes d'adressage et les électrodes des points d'affichage, par voie sèche.

On peut ainsi envisager le dépôt et la gravure de toutes les couches minces nécessaires à la fabrication d'un écran plat par des procédés plasma, ce qui permet par rapport à la voie humide utilisée actuellement une meilleure définition des motifs à graver, de la vitesse et du temps de gravure. Ceci permet en outre d'éviter l'attaque du substrat en fin de gravure et donc toute occlusion d'impuretés et en particulier de chlore dans le substrat. En outre, une méthode entièrement par voie sèche diminue le coût de fabrication de ces écrans.

Par ailleurs, dans les dispositifs à cristaux liquides, on utilise généralement des couches de polymère déposées par "voie humide" comme couche d'orientation du cristal liquide. Il a été montré que la couche de polymère obtenue selon le procédé de l'invention peut servir comme couche d'orientation du cristal liquide, en dehors de la zone des transistors.

Enfin, le polymère déposé peut également servir comme couche de passivation de l'écran plat à cristal liquide.

D'autres caractéristiques et avantages de l'invention ressortiront mieux de la description qui va suivre donnée à titre illustratif et non limitatif, en référence aux dessins annexés dans lesquels :

- la figure 1 représente, en coupe, les différentes étapes du procédé selon l'invention appliqué à la fabrication d'un transistor en couches minces,

- la figure 2 donne les caractéristiques statiques d'un transistor obtenu par le procédé selon l'invention,

- la figure 3 donne les caractéristiques d'un transistor réalisé dans des conditions strictement identiques à celui de l'invention mais n'ayant pas subi le procédé de gravure et de dépôt conforme à l'invention, et

- la figure 4 est une vue de dessus d'un point d'une matrice active d'un écran plat.

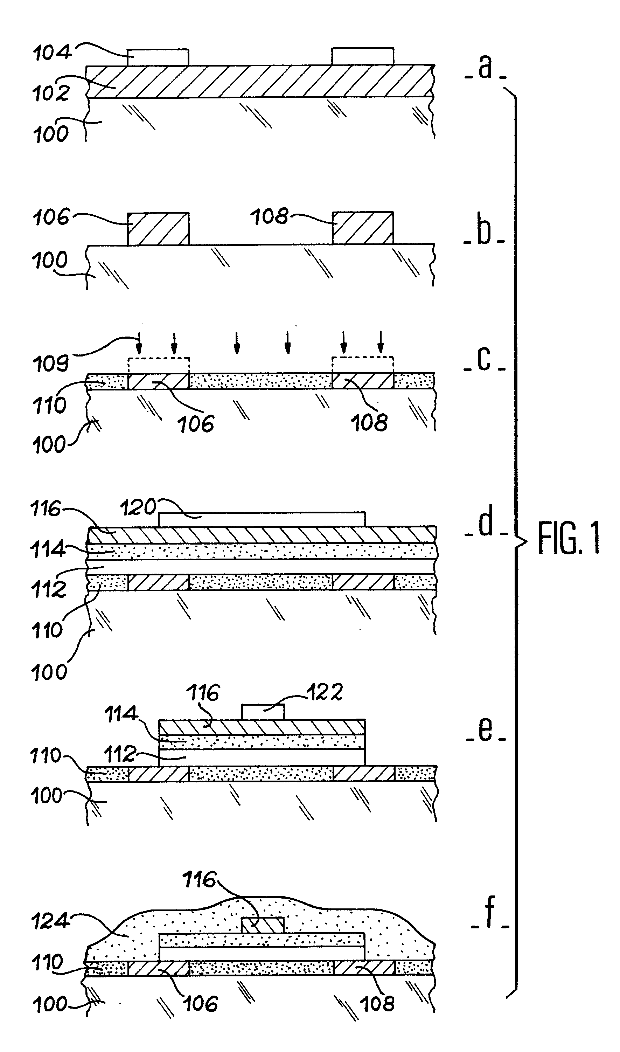

La première étape de fabrication d'un transistor en couches minces, masqué optiquement, consiste, comme représenté sur la partie a de la figure 1, à déposer sur un substrat 100 en verre une couche 102 d'ITO de 25 à 225nm d'épaisseur. Cette couche 102 est déposée par pulvérisation magnétron sous vide.

A L'aide d'un premier photomasque en résine 104, définissant l'emplacement de la source et du drain du transistor à réaliser, on effectue une première gravure de la couche 102 dans un bain d'acide chlorhydrique. Ce bain contient 37% d'acide chlorhydrique dilué à 50% dans de l'eau et porté à une température de 55 $^\circ$ C environ.

Dans un procédé complet par voie sèche, cette gravure chimique est effectuée avec un mélange de $CH_4 + H_2 + Ar$ avec des % en volume 10% $CH_4$-72% $H_2$-18% Ar.

Après élimination du masque 104 par un plasma d'oxygène, on obtient la structure représentée sur la partie b de la figure 1. Les plots d'oxyde 106 et 108 obtenus constitueront respectivement la source et le drain du transistor.

On expose ensuite l'ensemble de l'échantillon à un plasma 109 de $CH_4 + H_2 + Ar$, comme représenté sur la partie c. On obtient ainsi une gravure partielle des contacts source et drain 106 et 108 du transistor et conjointement un dépôt d'un film 110 de polymère sur toutes les surfaces du substrat non recouvertes d'oxyde métallique. Les organométalliques formés sont du type triméthylindium $I_4$-$(CH_3)_3$ et tétraméthylétain $Sn(CH_3)_4$.

Pour une tension d'autopolarisation du substrat 100 de 240 volts, une fréquence de 13,56 MHz, une pression de 60 mT (8 kPa) et des débits de gaz fixés à $CH_4 = 7cm^3/min$, $H_2 = 50cm^3/min$ et $Ar = 12cm^3/min$, on obtient une vitesse de gravure de 6nm/min de l'ITO et une vitesse de dépôt du polymère 110 de 4nm/min. Ces débits gazeux correspondent à un mélange gazeux de 10% de $CH_4$, 72% d'hydrogène et 18% d'argon, en volume.

Avec une couche 102 d'ITO de 125nm, on obtient une structure plane, la hauteur d'ITO gravé étant égale à la hauteur de polymère 110 déposé à 10nm près.

La fabrication du transistor se poursuit, comme représenté sur la partie d de la figure 1 par le dépôt d'une couche de silicium amorphe hydrogéné 112 sur l'ensemble de la structure, d'une couche de nitrure de silicium 114 et d'une couche métallique 116 en aluminium ou siliciure d'aluminium. Les couches 112 et 114 sont obtenues par dépôt chimique en phase vapeur assisté plasma et la couche d'aluminium 116 est déposée par évaporation ou pulvérisation. Ces couches 112, 114 et 116 ont une épaisseur respective de 20 nm, de 240 nm et de 200 nm.

On définit alors les dimensions du transistor à l'aide d'un photomasque 120 en résine réalisé selon les procédés connus. On effectue alors une gravure anisotrope par voie sèche des couches 114 et 112 et par voie humide de la couche 116. Les agents d'attaque sont respectivement un plasma d'hexafluorure de soufre ($SF_6$) pour les couches 114 et 112 et un bain d'acide orthophosphorique pour la couche 116. La structure obtenue est représentée sur la partie e de la figure 1.

Après élimination du masque de résine 120, il est éventuellement possible de former un photomasque 122 définissant les dimensions de la grille du transistor. A l'aide de ce masque 122, on effectue alors une gravure humide de la couche 116. Après élimination du masque 122 par un plasma d'oxygène, on passive l'ensemble de la structure par dépôt d'une couche 124 de nitrure de silicium, comme représenté sur la partie f.

Dans le cas d'une couche métallique 116 en un oxyde métallique conducteur (ITO en particulier), on peut utiliser le procédé de l'invention pour graver la couche 116 et former simultanément la couche de passivation 124 du transistor.

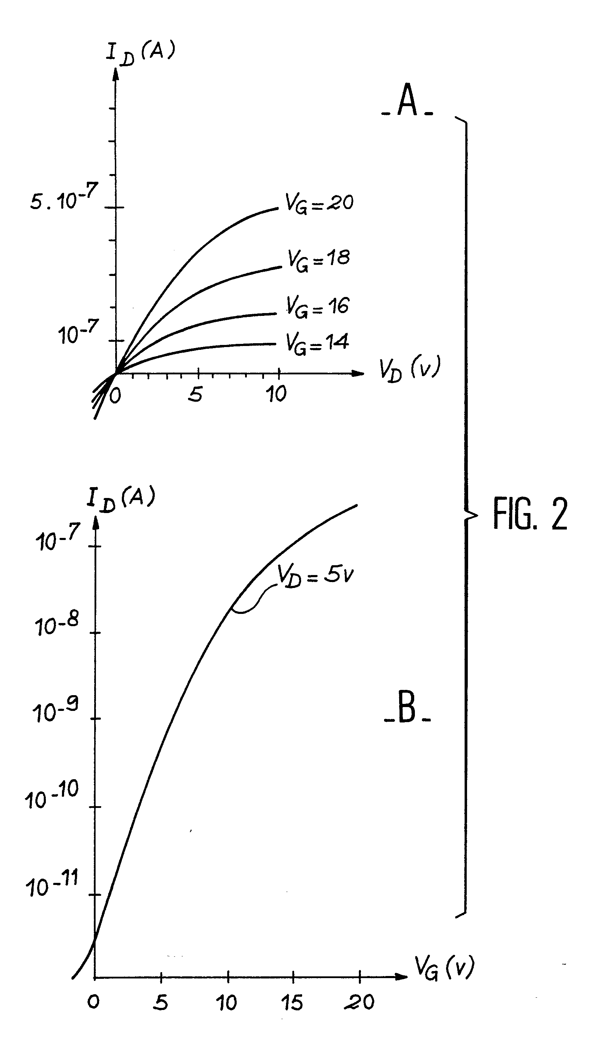

Les caractéristiques électriques statiques du transistor obtenu sont représentées sur la figure 2 ; ces caractéristiques sont établies pour des source et drain gravés par "voie humide". Les courbes de la partie A donnent les variations du courant drain ($I_D$) exprimées en ampère en fonction de la tension drain ($V_D$) exprimée en volt pour différentes tensions appliquées sur la grille ($V_G$) du transistor. La partie B de la figure 2 donne les variations du courant de drain, en ampère, en fonction de la tension grille appliquée pour une tension drain de 5 volts.

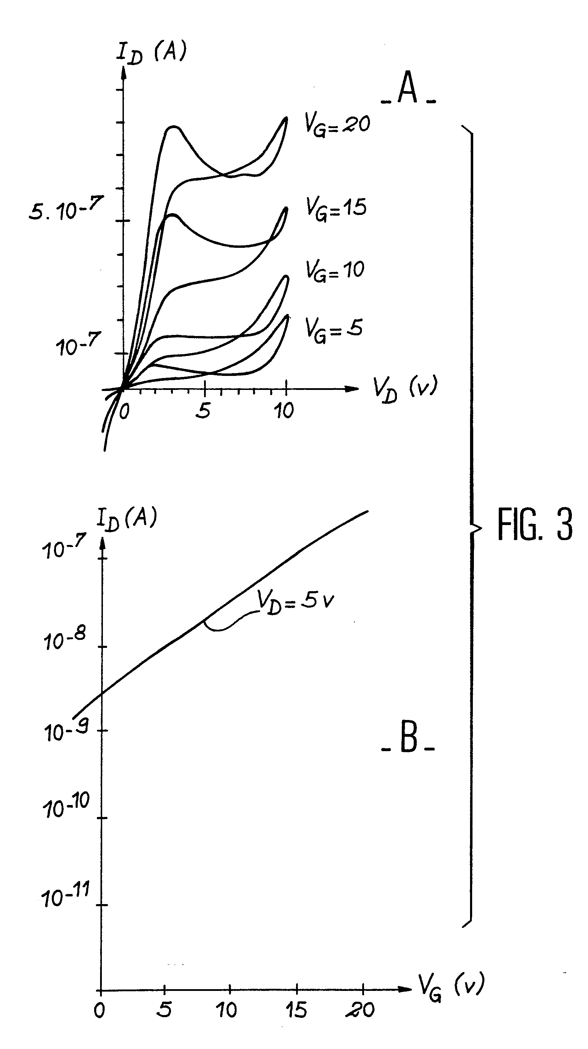

A titre de comparaison, on donne sur la figure 3 les caractéristiques électriques statiques d'un transistor réalisé dans les mêmes conditions que précédemment à l'exception de la gravure de l'ITO et du dépôt simultanés de polymère selon l'invention. La partie A de la figure 3 donne les variations de $I_D$ en fonction de $V_D$ pour différentes tensions grille $V_G$ et la partie B donne les variations de $I_D$ en fonction de $V_G$ pour une tension drain de 5 volts.

L'observation de ces courbes montre, d'une part, l'efficacité du dépôt de polymère en tant que couche de passivation du verre, et jouant alors le rôle de barrière à la diffusion des impuretés contenues dans le verre vers la couche semiconductrice du transistor, et, d'autre part, que les propriétés physiques de l'ITO sont conservées après gravure par plasma, le contact ITO/silicium amorphe hydrogéné n'étant pas dégradé.

En outre, avec le procédé de l'invention, on obtient un masque optique du transistor relativement efficace. Une absorption de l'ordre de 20% avec une longueur d'onde de 560 nm a été mesurée pour des films de polymère de 50 nm d'épaisseur.

Le procédé décrit en référence à la figure 1 est compatible avec le procédé de fabrication d'un écran d'affichage à matrice active décrite dans le document EP-A-0 10 3 523 et dans le document FR-A-2 571 893 du demandeur.

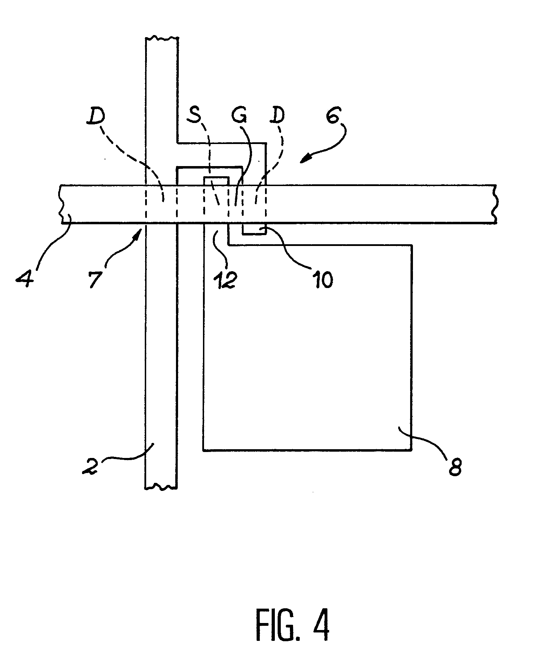

Dans un tel écran d'affichage à matrice active, chaque point de la matrice a la structure représentée sur la figure 4, en vue de dessus.

Sur cette figure, on voit une colonne conductrice 2 et une ligne conductrice 4 constituant les colonnes et les lignes d'adressage des points mémoires de la matrice active, deux TCM 6 et 7 montés en parallèle et une électrode transparente 8 constituant l'une des armatures des points élémentaires d'affichage (pixels) de la matrice active. Les TCM sont réalisés comme décrits précédemment.

Chaque colonne 2 est pourvue d'une crosse 10 et chaque électrode 8 d'un doigt 12. Les croisements de la ligne 4 avec la colonne 2 et la crosse 10 définissent les drains D des TCM et le croisement de la ligne 4 avec le doigt 12 définit la source S de ces TCM. La partie de la ligne 4 située entre la colonne 2 et la crosse 10 constitue la grille G des TCM.

Lors de la fabrication d'un écran d'affichage complet, le masque 104 servant à définir l'emplacement de la source et du drain des TCM 6 et 7 sert aussi à masquer l'électrode transparente 8 et les colonnes conductrices 2 de l'écran à réaliser. Les armatures 8 et les colonnes 2 sont alors formées en même temps que les contacts source et drain par gravure par voie humide de la couche d'ITO 102, voire par gravure par voie sèche, puis gravure par le procédé selon l'invention de cette même couche 102. Les espaces situés entre les armatures et les colonnes sont alors recouverts du polymère 110 selon l'invention.

Par ailleurs, les lignes d'adressage 4 de l'écran d'affichage sont formées simultanément à la grille du transistor, par gravure de la couche 116 une première fois à l'aide du masque 120 et une deuxième fois à l'aide du masque 122.

**Revendications**

1. Procédé de gravure anisotrope d'une couche d'oxyde métallique (102) par formation d'organométalliques, disposée sur un substrat (100), et simultanément dépôt d'un film de polymère (110) sur les parties du substrat, non pourvues d'oxyde, consistant à soumettre l'ensemble à un plasma formé à partir d'un mélange gazeux contenant de l'hydrogène et au moins un hydrocarbure qui, par dissociation, conduit à la formation du polymère (110) et à ladite gravure en réagissant chimiquement avec la couche d'oxyde.

2. Procédé selon la revendication 1, caractérisé en ce que le mélange gazeux contient en volume :
de 10% à 88% d'hydrogène,
de 2% à 30% d'au moins un hydrocarbure,
de 10% à 50% d'au moins un gaz vecteur inerte.

3. Procédé selon la revendication 1 ou 2, caractérisé en ce que le mélange gazeux contient en volume :
de 45 à 81% d'hydrogène,
de 4 à 20% d'au moins un hydrocarbure,
de 15 à 35% d'au moins un gaz vecteur inerte.

4. Procédé selon l'une quelconque des revendications 1 à 3, caractérisé en ce que l'hydrocarbure est du méthane.

5. Procédé selon l'une quelconque des revendications 1 à 4, caractérisé en ce que le mélange gazeux contient de l'argon.

6. Procédé selon l'une quelconque des revendications 1 à 5, caractérisé en ce que le mélange gazeux contient 72% d'hydrogène, 10% de méthane et 18% d'argon.

7. Procédé selon l'une quelconque des revendications 1 à 6, caractérisé en ce que le mélange gazeux présente une pression allant de 1,35 à 13,5 kPa.

8. Procédé selon l'une quelconque des revendications 1 à 7, caractérisé en ce que l'on utilise une tension de polarisation du substrat (100) inférieure à 250 V.

9. Procédé selon l'une quelconque des revendications 1 à 8, caractérisé en ce que la couche d'oxyde (102) est formée d'un matériau conducteur électrique et transparent choisi parmi ITO, $SnO_2$, et $In_2O_3$.

10. Procédé selon l'une quelconque des revendications 1 à 9, caractérisé en ce que le substrat est un matériau isolant transparent.

11. Procédé de fabrication d'un transistor en couches minces sur un substrat isolant (100), comprenant les étapes suivantes :

(a) formation, sur le substrat (100), de la source (106) et du drain (108) du transistor en un oxyde métallique (102) conducteur,

(b) gravure chimique anisotrope partielle de l'oxyde métallique et dépôt d'un film de polymère (110) sur le substrat dépourvu dudit oxyde métallique par le procédé selon l'une quelconque des revendications 1 à 10, ce dépôt de polymère constituant une passivation du substrat (100) et/ou un masque optique sous le canal du transistor,

(c) dépôts successifs, sur la structure obtenue en (b), d'une couche de silicium amorphe hydrogéné (112), d'une couche d'isolant électrique (114) puis d'une couche conductrice (116),

(d) photogravure de l'empilement formé par la couche de silicium, la couche d'isolant et la couche conductrice pour former la grille du transistor.

12. Procédé selon la revendication 11, caractérisé en ce que les étapes (a) à (d) sont réalisées par voie sèche.

13. Procédé selon la revendication 11 ou 12, caractérisé en ce que l'épaisseur de polymère déposé et l'épaisseur de l'oxyde métallique restant après la gravure sont égales de façon à obtenir un transistor à structure plane.

EP 0 377 365 A1

FIG.1

FIG. 2

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | JAPANESE JOURNAL OF APPLIED PHYSICS, vol. 27, no. 9, septembre 1988, pages L1753-L1756; T. MINAMI et al.: "Reactive ion etching of transparent conducting tin oxide films using electron cyclotron resonance hydrogen plasma" * Résumé * --- | 1-8 | H 01 L 21/321<br>H 01 L 21/312<br>H 01 L 21/336<br>H 01 L 27/13 |
| D,A | ELECTRONICS LETTERS, vol. 23, no. 24, 19 novembre 1987, pages 1253-1254; L. HENRY et al.: "Novel process for integration of optoelectronic devices using reactive ion etching without chlorinated gas" * Page 1253, colonne de gauche, paragraphe 6 * --- | 1-8 | |
| A | US-A-4 778 562 (GENERAL MOTORS) * Revendications * --- | 1-8 | |
| A | US-A-4 750 980 (TEXAS INSTRUMENTS) * Revendication 1 * --- | 1-8 | **DOMAINES TECHNIQUES RECHERCHES (Int. Cl.5)** |
| D,A | EP-A-0 103 523 (COISSARD) * Revendications * ----- | 11-13 | H 01 L |

Le présent rapport a été établi pour toutes les revendications

| Lieu de la recherche | Date d'achevement de la recherche | Examinateur |
|---|---|---|
| LA HAYE | 07-03-1990 | GORI P. |

EPO FORM 1503 03.82 (P0402)